# EUROPEAN PATENT APPLICATION

(11) **EP 4 818 882 A1**
(43) Date of publication of application: **07.10.2026**
(21) Application number: 25218901.4
(22) Date of filing: 27.11.2025
(51) Int. Cl.: G06F 7/544, G06F 7/57, G06F 9/30, H03K 19/20

(54) **ARITHMETIC CIRCUIT AND MEMORY INCLUDING THE SAME**

(30) Priority: 02.04.2025 KR 20250042524
(71) Applicant: SK hynix Inc., Bubal-eub Icheon-si Gyeonggi-do 17336 (KR)
(72) Inventor: KO, Geon, 17336 Icheon-si, Gyeonggi-do (KR)
(74) Representative: Isarpatent

(57) **Abstract**

An arithmetic circuit includes an arithmetic matrix including a plurality of arithmetic units each configured to receive one of a plurality of bits of an X input and one of a plurality of bits of a Y input and configured to perform an arithmetic operation on the received bits and an adder array configured to generate a result value by adding operation results of the arithmetic matrix. A first group, among the plurality of arithmetic units, outputs the results of an AND operation by performing the AND operation on its own input values. A second group, among the plurality of arithmetic units, outputs the results of different arithmetic operations by performing the different arithmetic operations in a high-precision operation mode and a low-precision operation mode.

## Description

### BACKGROUND

### 1. Technical Field

Embodiments relate to an arithmetic circuit and memory including the same.

### 2. Related Art

An electronic device includes many electronic components. A computer system may include many electronic components including semiconductors, among the electronic components. A host device, such as a processor or a memory controller, among the semiconductors constituting the computer system, may perform data communication with memory. The memory includes many memory cells arranged in multiple rows and multiple columns and may store data.

Recently, in order to improve performance of data processing, technologies in which memory is used in an arithmetic operation are being developed. When memory directly performs an arithmetic operation therein without transmitting data to a processor, delay due to movement of the data can be reduced and energy efficiency can be improved.

### SUMMARY

In an embodiment, an arithmetic circuit may include an arithmetic matrix including a plurality of arithmetic units each configured to receive one of a plurality of bits of an X input and one of a plurality of bits of a Y input and configured to perform an arithmetic operation on the received bits and an adder array configured to generate a result value by adding operation results of the arithmetic matrix. A first group, among the plurality of arithmetic units, may output the results of an AND operation by performing the AND operation on its own input values. A second group, among the plurality of arithmetic units, may output the results of different arithmetic operations by performing the different arithmetic operations in a high-precision operation mode and a low-precision operation mode.

In an embodiment, an arithmetic circuit may include an arithmetic matrix including sixty-four arithmetic units arranged 8×8 and each configured to receive one of 8 bits of an X input and one of 8 bits of a Y input and configured to perform an arithmetic operation on the received bits and an adder array configured to generate a result value by adding operation results of the arithmetic matrix. A first group, among the plurality of arithmetic units, may output the results of an AND operation by performing the AND operation on values that are input to respective arithmetic units. A second group, among the plurality of arithmetic units, may output the results of different arithmetic operations by performing the different arithmetic operations in a high-precision operation mode and a low-precision operation mode.

In an embodiment, memory may include a cell array, an input register configured to transmit 8 bits of a first input that is read from the cell array as 8 bits of an X input and configured to transmit 8 bits of a second input that is received from an outside of the memory as 8 bits of a Y input, an arithmetic matrix including sixty-four arithmetic units arranged 8×8 and each configured to receive one of the 8 bits of the X input and one of the 8 bits of the Y input and configured to perform an arithmetic operation on the received bits, and an adder array configured to generate a result value by adding operation results of the arithmetic matrix. A first group, among the plurality of arithmetic units, may output the results of an AND operation by performing the AND operation on values that are input to respective arithmetic units. A second group, among the plurality of arithmetic units, may output the results of different arithmetic operations by performing the different arithmetic operations in a high-precision operation mode and a low-precision operation mode.

### BRIEF DESCRIPTION OF THE DRAWINGS

FIG. 1 is a construction diagram of memory 100 according to an embodiment of the present disclosure.
FIG. 2 is a construction diagram according to another embodiment of a MAC arithmetic element 150 illustrated in FIG. 1.
FIG. 3 is a diagram illustrating an arithmetic circuit 210_0.
FIGS. 4 to 7 are diagrams that represent a process of performing a multiplication operation of INT8 and a process of performing an addition operation on multiplication operations of INT4 and multiplication results thereof.
FIG. 8 is a construction diagram according to another embodiment of the arithmetic circuit 210_0 illustrated in FIG. 3.
FIG. 9 is a construction diagram according to an embodiment of an input register 810 illustrated in FIG. 8.
FIG. 10 is a construction diagram according to an embodiment of an arithmetic matrix 820 illustrated in FIG. 8.
FIG. 11 is a construction diagram according to an embodiment of a first arithmetic unit AND.
FIG. 12 is a construction diagram according to an embodiment of a second arithmetic unit 0.
FIG. 13 is a construction diagram according to an embodiment of a third arithmetic unit 1.
FIG. 14 is a construction diagram according to an embodiment of a fourth arithmetic unit 2_0.
FIG. 15 is a construction diagram according to an embodiment of a fifth arithmetic unit 2_1.
FIG. 16 is a construction diagram according to an embodiment of a sixth arithmetic unit 2_2.
FIG. 17 is a construction diagram according to an embodiment of a seventh arithmetic unit 3.
FIG. 18 is a construction diagram according to an embodiment of an adder array 830 illustrated in FIG. 8.
FIGS. 19 and 20 are diagrams illustrating an example of an arithmetic operation of the arithmetic circuit 210_0.

### DETAILED DESCRIPTION

Hereinafter, embodiments according to the technical spirit of the present disclosure are described with reference to the accompanying drawings.

Embodiments of the present disclosure may provide a technology which enables an arithmetic operation in a high-precision operation mode and a low-precision operation mode by using the same construction.

According to embodiments of the present disclosure, it is possible to perform an arithmetic operation in the high-precision operation mode and the low-precision operation mode by using the same construction.

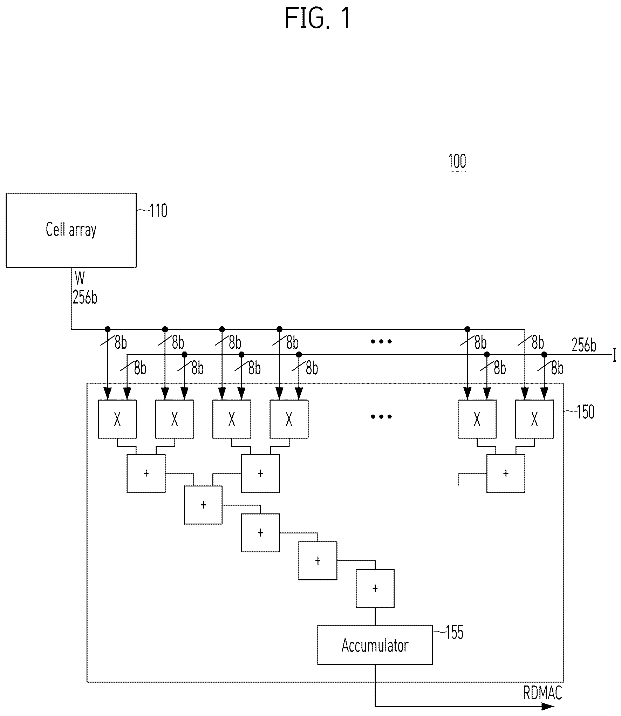

FIG. 1 is a construction diagram of memory 100 according to an embodiment of the present disclosure.

Referring to FIG. 1, the memory 100 includes a multiplication and accumulation (MAC) arithmetic element 150 in order to support an operation within the memory 100 in addition to a cell array 110 in which data are stored. The MAC arithmetic element 150 is an operator that supports an MAC operation that is used in a large language model (LLM) of artificial intelligence (AI).

The MAC arithmetic element 150 may perform a MAC operation on data read from the cell array 110 and data input from a device external to the memory 100. The cell array 110 may store a value of a weight W of a MAC operation, which is not frequently changed in general. Input data I may be provided from a device external to the memory 100.

FIG. 1 illustrates that a MAC operation is performed with precision of a 32-bit integer type INT8. A 256-bit weight W read from the cell array 110 may be divided into 8 bits and input to thirty-two multipliers X. 256-bit input data I from a device external to the memory 100 may also be divided into 8 bits and input to the thirty-two multipliers X.

Each of the thirty-two multipliers X may multiply and output the 8-bit weight and the 8-bit input data that are input to each multiplier. The outputs of the thirty-two multipliers X may be added by adders + arranged in an adder tree form and may be input to an accumulator 155. Furthermore, the accumulator 155 may output the results of MAC operations that are performed by the thirty-two multipliers X and the adders + by accumulating the results of the MAC operations. That is, the accumulator 155 may output the results of the MAC operations (RDMAC) that are performed several times by accumulating the results of the MAC operations.

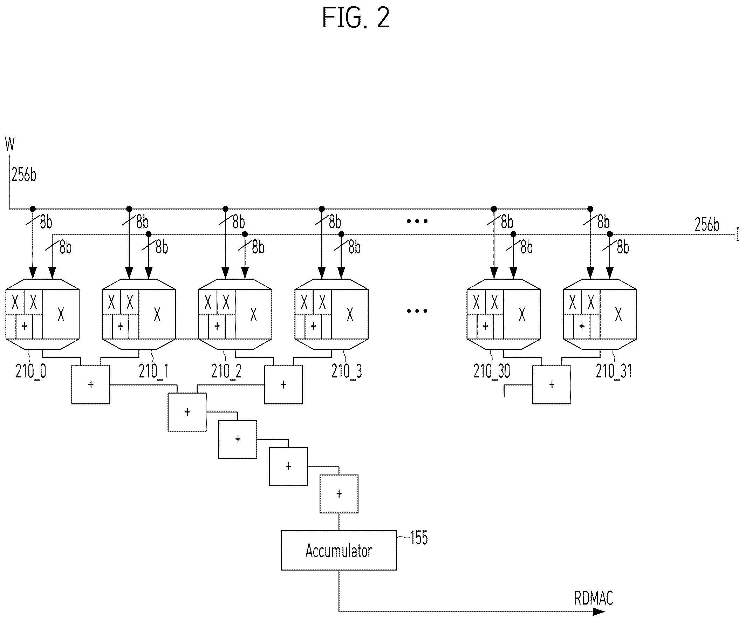

FIG. 2 is a construction diagram according to another embodiment of the MAC arithmetic element 150 illustrated in FIG. 1.

The MAC arithmetic element 150, illustrated in FIG. 1, may support only one precision INT8 operation. In contrast, a MAC arithmetic element 150, illustrated in FIG. 2, may be configured to be capable of supporting both an INT8 high-precision arithmetic operation and an INT4 low-precision arithmetic operation. Referring to FIG. 2, the thirty-two multipliers X in FIG. 1 may be substituted with arithmetic circuits 210_0 to 210_31.

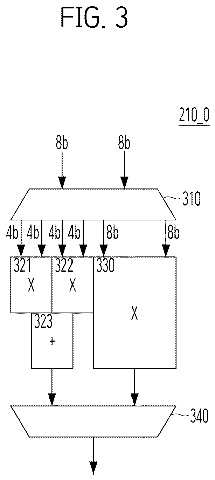

FIG. 3 illustrates the arithmetic circuit 210_0. The arithmetic circuit 210_0 includes a selection circuit 310, two multipliers (X) 321 and 322 for INT4, an adder (+) 323, a multiplier (X) 330 for INT8, and a selection circuit 340.

At the start of an INT8 high-precision arithmetic operation, the selection circuit 310 may transmit the 8-bit weight and the 8-bit input to the multiplier 330 for INT8. The multiplier 330 for INT8 may multiply and output the 8-bit weight and the 8-bit input. Furthermore, the selection circuit 340 may output the results of the multiplication of the multiplier 330 for INT8.

At the start of an INT4 low-precision arithmetic operation, the selection circuit 310 may transmit the 8-bit weight to the multipliers 321 and 322 for INT4 by 4 bits and may transmit the 8-bit input to the multipliers 321 and 322 for INT4 by 4 bits. Each of the multipliers 321 and 322 for INT4 may multiply and output the 4-bit weight and the 4-bit input that are input to each multiplier. The adder 323 may add and output the outputs of the multipliers 321 and 322 for INT4. Furthermore, the selection circuit 340 may output the results of the addition of the adder 323.

Referring to FIGS. 2 and 3, in order to support the two types of precision operations, the two types of different multipliers 321 and 322, and 330 are required. That is, the thirty-two multipliers 330 for INT8 and the sixty-four multipliers 321 and 322 for INT4 need to be separately provided. This may result in a greater burden from an area perspective.

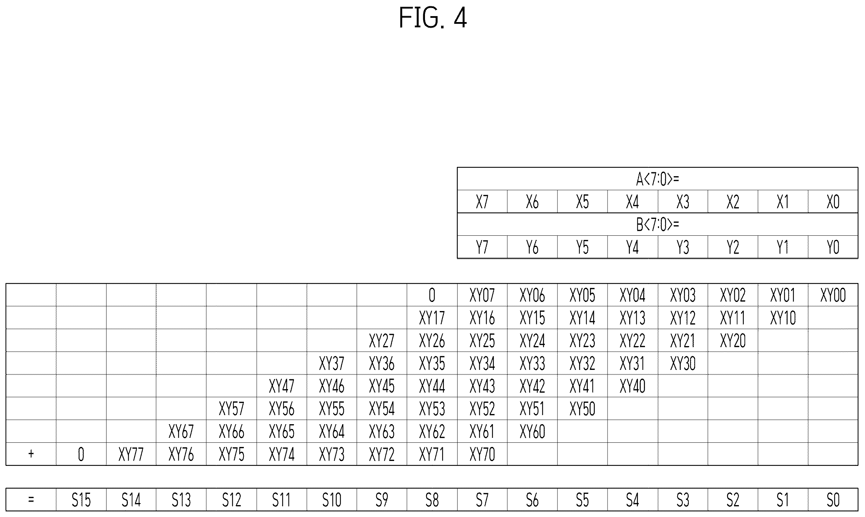

FIGS. 4 to 7 are diagrams that represent a process of performing a multiplication operation of INT8 and a process of performing an addition operation on multiplication operations of INT4 and multiplication results thereof.

FIG. 4 represents an arithmetic operation of A<7:0> * B<7:0> = S<15:0>, that is, an unsigned INT8 multiplication operation. In this case, A<7:0> may be an 8-bit value read from the cell array 110. B<7:0> may be an 8-bit value that is input from a device external to the memory 100. An AND operation of an XN bit and a YM bit (N and M are each an arbitrary integer), that is, XN AND YM, is represented as XYNM, for example, X0 AND Y7 = XY07 and X3 AND Y2 = XY32.

In A<7:0> * B<7:0>, that is, an unsigned INT8 multiplication operation, when bits corresponding to binary digits of A and B, respectively, may be subjected to an AND operation and the results of all of the AND operations are then added, the results S<15:0> of the operation may be derived.

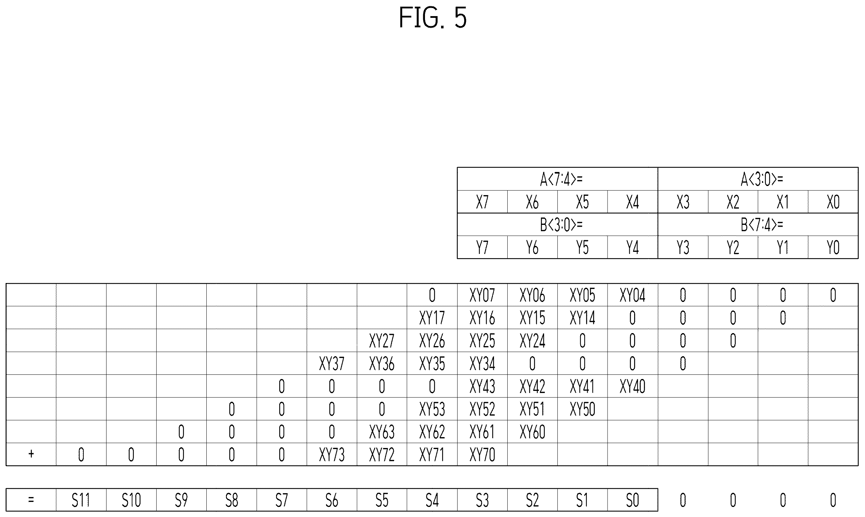

FIG. 5 represents an arithmetic operation of A<7:4> * B<7:4> + A<3:0> * B<3:0> = S<11:0>, that is, an unsigned INT4 operation. It may be seen that the arithmetic operation of A<7:4> * B<7:4> + A<3:0> * B<3:0> = S<11:0> is possible by substituting some AND operations in the arithmetic operation of FIG. 4 with 0. For example, it may be seen that the arithmetic operation of A<7:4> * B<7:4> + A<3:0> * B<3:0> = S<11:0> is possible by substituting XY13, XY22, XY31, etc. in FIG. 4 with 0 and adding the results of AND operations.

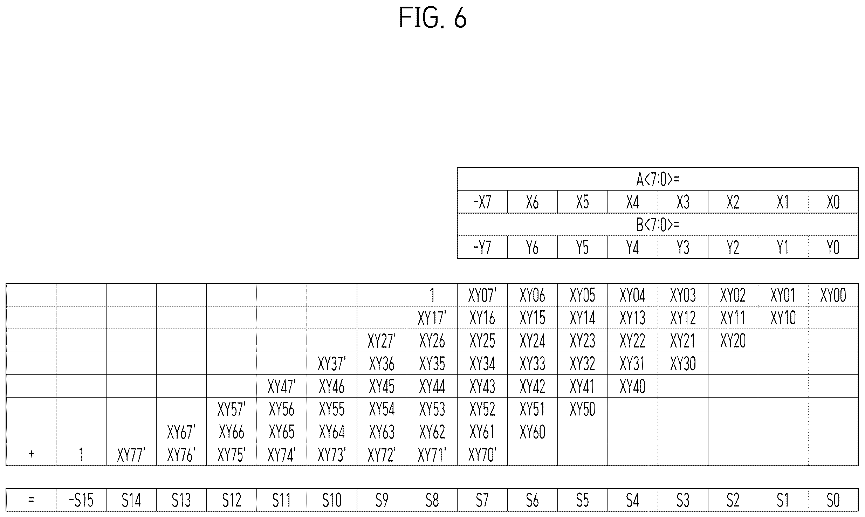

FIG. 6 represents an arithmetic operation of A<7:0> * B<7:0> = S<15:0>, that is, a signed INT8 multiplication operation. A bit represented by "-" (i.e., -X7, -Y7, or -S15) is a bit indicative of a sign. The signed INT multiplication operation may also require a NAND operation in addition to an AND operation. A NAND operation of an XN bit and a YM bit, that is, XN NAND YM, is represented as XYNM', for example, X0 NAND Y7 = XY07'. In the signed type, the most significant bit has a minus value, for example, A = 8'b(8-bit binary number)10000001 = -128+1 = -127. In FIG. 6, it may be seen that 0 in FIG. 4 has been changed to 1. This is based on the conversion of X = X'-1 (e.g., -1 = 0-1) and the representation of S = 8'b11111111 = -1 because an operation for -1 is not present in a digital logic gate.

When the results of all logical operations are added, the results S<15:0> of the operations may be derived, and S15 may indicate a sign.

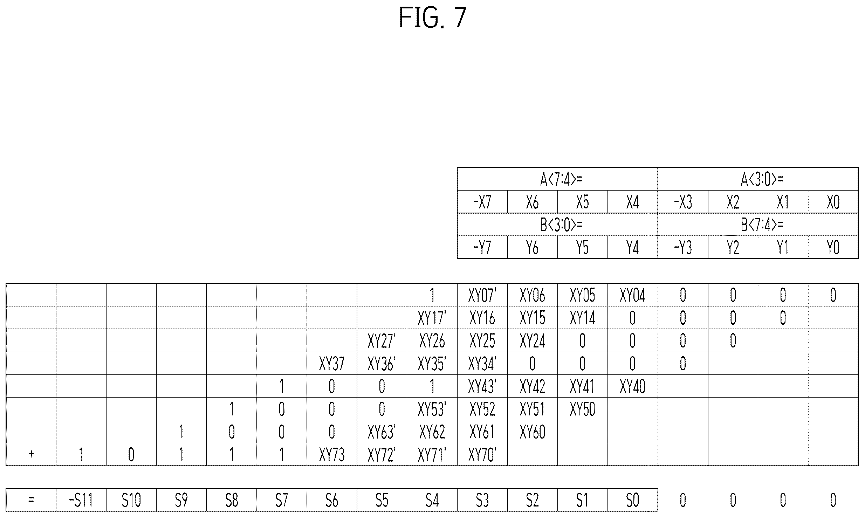

FIG. 7 represents an arithmetic operation of A<7:4> * B<7:4> + A<3:0> * B<3:0> = S<11:0>, that is, a signed INT4 operation. In FIG. 7, some of the AND operations in FIG. 5 may be changed into NAND operations, and some of 0's in FIG. 5 may be changed into 1. The reason why some of the 0's in FIG. 5 are changed into 1 is for incorporating a sign in the bit S11, among the result values of the operations.

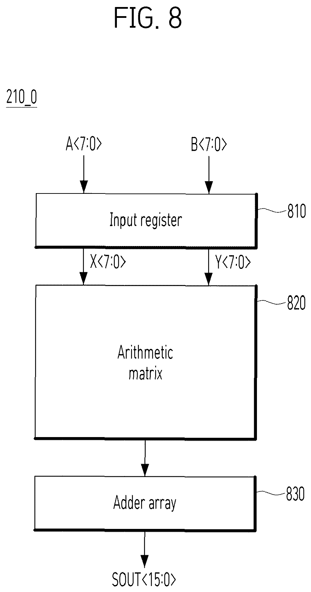

FIG. 8 is a construction diagram according to another embodiment of the arithmetic circuit 210_0 illustrated in FIG. 3.

The arithmetic circuit 210_0, illustrated in FIG. 3, inevitably has a wide area because the two multipliers 321 and 322 for INT4 and the multiplier 330 for INT8 have to be separately provided. In contrast, the arithmetic circuit 210_0, illustrated in FIG. 8, can prevent an increase in area because components for INT8 multiplication are also used for INT4 multiplication by using the redundancy of the INT8 and INT4 signed and unsigned operation processes described with reference to FIGS. 4 to 7.

In the following Table 1, signals EN_INT8, EN_INT4, SIGN, EN_SINT8, and EN_SINT4 for indicating modes are used. Table 1 summarizes the levels of the signals EN_INT8, EN_INT4, SIGN, EN_SINT8, and EN_SINT4 in the modes.

**Table 1**

| | Unsigned INT8 | Unsigned INT4 | Signed INT8 | Signed INT4 |
|---|---|---|---|---|
| EN_INT8 | 1 | 0 | 1 | 0 |
| EN_INT4 | 0 | 1 | 0 | 1 |
| SIGN | 0 | 0 | 1 | 1 |
| EN_SINT8 | 0 | 0 | 1 | 0 |
| EN_SINT4 | 0 | 0 | 0 | 1 |

The high-precision operation mode INT8 and the low-precision operation mode INT4 are present, and a signed operation and an unsigned operation are present.

Unsigned INT8 means that an unsigned operation is performed in the high-precision operation mode. The arithmetic circuit 210_0 performs the arithmetic operation of A<7:0> * B<7:0> = S<15:0> (FIG. 4). In this case, the output of the arithmetic circuit 210_0 is SOUT<15:0> = S<15:0>.

Unsigned INT4 means that an unsigned operation is performed in the low-precision operation mode. The arithmetic circuit 210_0 performs the arithmetic operation of A<7:4> * B<7:4> + A<3:0> * B<3:0> = S<11:0> (FIG. 5). In this case, the output of the arithmetic circuit 210_0 is SOUT<15:4> = S<11:0>.

Signed INT8 means that a signed operation is performed in the high-precision operation mode. The arithmetic circuit 210_0 performs the arithmetic operation of A<7:0> * B<7:0> = S<15:0> (FIG. 6). In this case, the output of the arithmetic circuit 210_0 is SOUT<15:0> = S<15:0>.

Signed INT4 means that a signal operation is performed in the low-precision operation mode. The arithmetic circuit 210_0 performs the arithmetic operation of A<7:4> * B<7:4> + A<3:0>*B<3:0> = S<11:0> (FIG. 7). In this case, the output of the arithmetic circuit 210_0 is SOUT<15:4> = S<11:0>.

Referring to FIG. 8, the arithmetic circuit 210_0 includes an input register 810, an arithmetic matrix 820, and an adder array 830.

The input register 810 may transmit the bits A<7:0> of a first input as the bits X<7:0> of an X input, and may transmit the bits B<7:0> of a second input as the bits Y<7:0> of a Y input. When the signal INT4 is 0, that is, in the high-precision operation mode, the input register 810 may transmit the 0-th bit to seventh bit A<7:0> of the first input as the 0-th bit to seventh bit X<7:0> of the X input X<7:0> and may transmit the 0-th bit to seventh bit B<7:0> of the second input as the 0-th bit to seventh bit Y<7:0> of the Y input Y<7:0>. In contrast, when the signal INT4 is 1, that is, in the low-precision operation mode, the input register 810 may transmit the 0-th bit to seventh bit A<7:0> of the first input as the 0-th bit to seventh bit X<7:0> of the X input, transmit the 0-th bit to third bit B<3:0> of the second input as the fourth bit to seventh bit Y<7:4> of the Y input, and transmit the fourth bit to seventh bit B<7:4> of the second input as the 0-th bit to third bit Y<3:0> of the Y input. The reason for this is that, as illustrated in FIGS. 5 and 7, in the low-precision operation mode, corresponding relations between the bits of the second input B<7:0> and the bits of the Y input Y<7:0> are different from those in FIGS. 4 and 6 in the high-precision operation mode.

The arithmetic matrix 820 includes multiple arithmetic units. Each of the multiple arithmetic units may perform an operation by receiving one of the bits of the X input and one of the bits of the Y input. Values, such as XY05 and XY14 in FIGS. 4 to 7, may be generated by the arithmetic matrix 820.

The adder array 830 may generate a result value SOUT<15:0> by adding the operation results of the arithmetic matrix 820. The adder array 830 may perform the addition operations described with reference to FIGS. 4 to 7. For example, the adder array 830 may perform an operation that generates S<1> by adding XY01 and XY10 in FIG. 4 and generates S<2> by adding a carry that comes over from a low-digit number and XY02, XY11, and XY20.

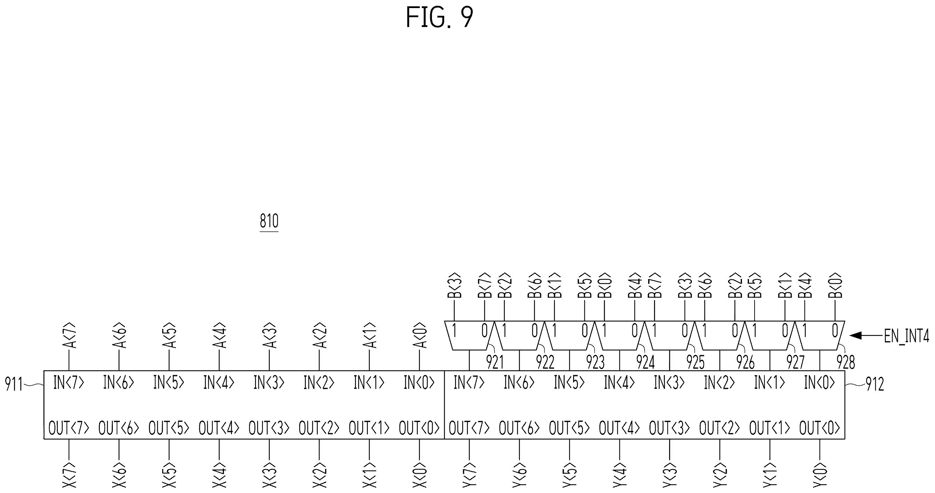

FIG. 9 is a construction diagram according to an embodiment of the input register 810 illustrated in FIG. 8.

Referring to FIG. 9, the input register 810 includes 8-bit latches 911 and 912 and selection circuits 921 to 928.

The 8-bit latch 911 outputs the X input X<7:0> by receiving the first input A<7:0>. A bit of the first input A<7:0> and a bit of the X input X<7:0>, which have the same number, may correspond to each other, for example, A<5>=X<5> and A<2>=X<2>.

When the level of the signal EN_INT4 is 1, that is, in the low-precision operation mode, each of the selection circuits 921 to 928 may select and output a signal that is input to its own terminal 1. Furthermore, when the level of the signal EN_INT4 is 0, that is, in the high-precision operation mode, each of the selection circuits 921 to 928 may select and output a signal that is input to its own terminal 0.

The 8-bit latch 912 may store a signal that is input to its own IN<k> terminal and may output the stored signal to its own OUT<k> terminal (k is an integer of 0 to 7). When the level of the signal EN_INT4 is 0, a bit of the second input B<7:0> and a bit of the Y input X<7:0>, which have the same number, may correspond to each other. In contrast, when the level of the signal EN_INT4 is 1, the bits B<3:0> of the second input may correspond to the bits Y<7:4> of the Y input, and the bits B<7:4> of the second input may correspond to the bits Y<3:0> of the Y input.

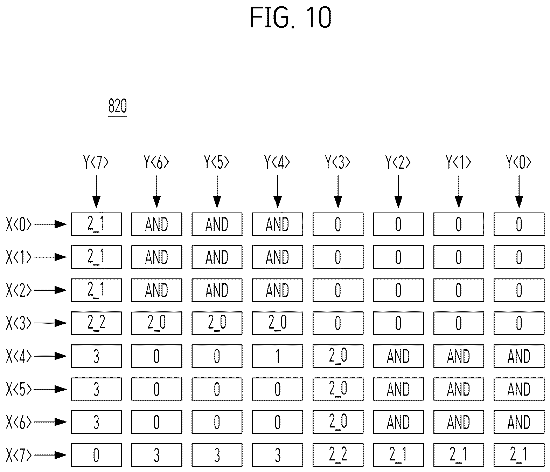

FIG. 10 is a construction diagram according to an embodiment of the arithmetic matrix 820 illustrated in FIG. 8.

Referring to FIG. 10, the arithmetic matrix 820 may include arithmetic units AND, 0, 1, 2_0, 2_1, 2_2, and 3.

Each of the arithmetic units AND, 0, 1, 2_0, 2_1, 2_2, and 3 may perform an arithmetic operation by receiving one bit of the X input X<7:0> and one bit of the Y input Y<7:0>.

The arithmetic units AND, 0, 1, 2_0, 2_1, 2_2, and 3 are divided into seven types.

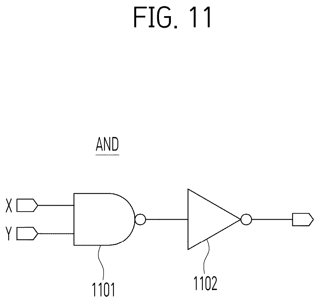

A first arithmetic units AND may output the results of an AND operation by performing the AND operation on values that are input to the first arithmetic units AND. It may be seen that in the arithmetic matrix 820, arithmetic units for (0,4) to (2,6) and arithmetic units (4,0) to (6,2) on the basis of a bit of the X input and a bit of the Y input are first arithmetic units AND. The first arithmetic unit AND for (0,4) may perform an arithmetic operation of XY04 in FIGS. 4 to 7. The first arithmetic unit AND for (6,2) may perform an arithmetic operation of XY62 in FIGS. 4 to 7. FIG. 11 illustrates an embodiment of the first arithmetic unit AND. The first arithmetic unit AND includes a NAND gate 1101 and an inverter 1102 and may output the results of an AND operation by performing the AND operation on input signals X and Y.

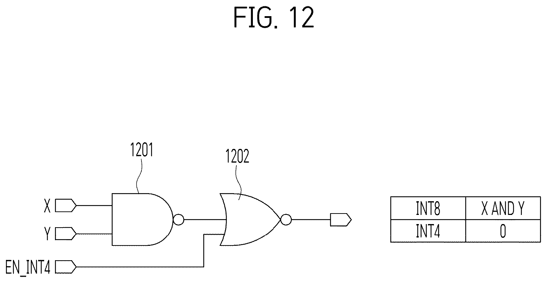

Each of the second arithmetic units 0 may output the results of an AND operation by performing the AND operation on input values that are input to each arithmetic unit in the high-precision operation mode and may output 0 in the low-precision operation mode. It may be seen that in the arithmetic matrix 820, arithmetic units for (0,0) to (3,3), arithmetic units for (4,5) to (6,6), an arithmetic unit for (5,4) and an arithmetic unit for (6,4) on the basis of a bit of the X input and a bit of the Y input are second arithmetic units 0. The second arithmetic unit 0 for (0,0) may perform an arithmetic operation of XY00 in FIGS. 4 and 6 and a 0 output operation in FIGS. 5 and 7. The second arithmetic unit 0 for (4,5) may perform an arithmetic operation of XY45 in FIGS. 4 and 6 and a 0 output operation in FIGS. 5 and 7. FIG. 12 illustrates an embodiment of the second arithmetic unit 0. It may be seen that the second arithmetic unit 0 includes a NAND gate 1201 and a NOR gate 1202. The second arithmetic unit 0 may output the results of an AND operation by performing the AND operation on input signals X and Y in the low-precision operation mode in which the signal EN_INT4 is 0. In the high-precision operation mode in which the signal EN_INT4 is 1, the output of the second arithmetic unit 0 may be fixed to 0.

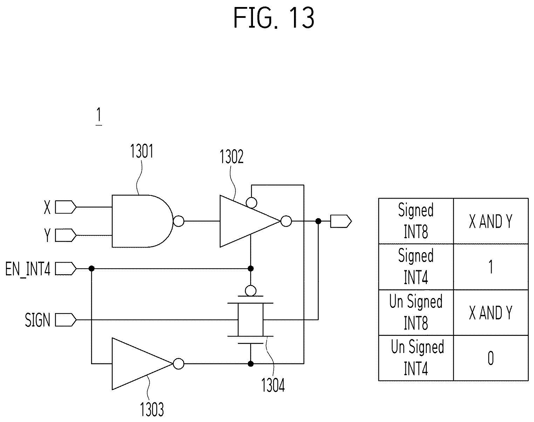

A third arithmetic unit 1 may output the results of an AND operation by performing the AND operation on input values that are input to the third arithmetic unit 1 in the high-precision operation mode, output 1 after the start of a signed operation in the low-precision operation mode, and output 0 after the start of an unsigned operation in the low-precision operation mode. It may be seen that in the arithmetic matrix 820, an arithmetic unit for (4,4) is the third arithmetic unit 1 on the basis of a bit of the X input and a bit of the Y input. The third arithmetic unit 1 for (4,4) may perform an arithmetic operation of XY44 in FIGS. 4 and 6, a 0 output operation in FIG. 5, and a 1 output operation in FIG. 6. FIG. 13 illustrates an embodiment of the third arithmetic unit 1. It may be seen that the third arithmetic unit 1 includes a NAND gate 1301, a tri-state inverter 1302, an inverter 1303, and a pass gate 1304. The third arithmetic unit 1 may output the results of an AND operation by performing the AND operation on input signals X and Y in the high-precision operation mode in which the signal EN_INT8 is 1. In the low-precision operation mode in which the signal EN_INT8 is 0, the third arithmetic unit 1 may output 1 after the start of a signed operation in which the signal SIGN is 1 and may output 0 after the start of an unsigned operation in which the signal SIGN is 0.

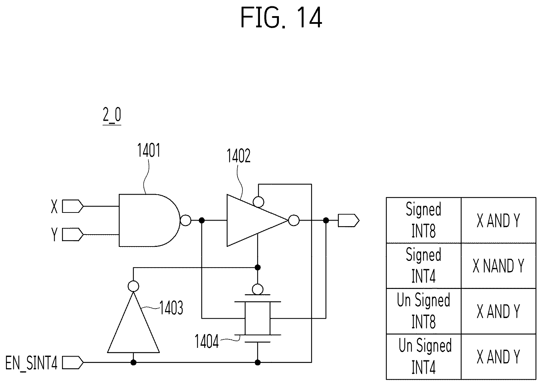

A fourth arithmetic unit 2_0 may output the results of an AND operation by performing the AND operation on input values that are input to the fourth arithmetic unit 2_0 after the start of a signed operation in the high-precision operation mode, output the results of a NAND operation by performing the NAND operation on input values that are input to the fourth arithmetic unit 2_0 after the start of a signed operation in the low-precision operation mode, and output the results of an AND operation by performing the AND operation on input values that are input to the fourth arithmetic unit 2_0 after the start of an unsigned operation in the high-precision operation mode and the low-precision operation mode. It may be seen that in the arithmetic matrix 820, arithmetic units for (3,4) to (3,6) and arithmetic units for (4,3) to (6,3) on the basis of a bit of the X input and a bit of the Y input are the fourth arithmetic units 2_0. The fourth arithmetic unit 2_0 for (3,4) may perform an arithmetic operation of XY34 in FIG. 4, FIG. 5, and FIG. 6 and may perform an arithmetic operation of XY34' in FIG. 7. FIG. 14 illustrates an embodiment of the fourth arithmetic unit 2_0. It may be seen that the fourth arithmetic unit 2_0 includes a NAND gate 1401, a tri-state inverter 1402, an inverter 1403, and a pass gate 1404. The fourth arithmetic unit 2_0 may output the results of a NAND operation by performing the NAND operation on input signals X and Y that are input to the fourth arithmetic unit 2_0 after the start of a signed operation in the low-precision operation mode in which the signal EN_SINT4 is 1 and may output the results of an AND operation by performing the AND operation on the input signals X and Y that are input to the fourth arithmetic unit 2_0 in the remaining cases.

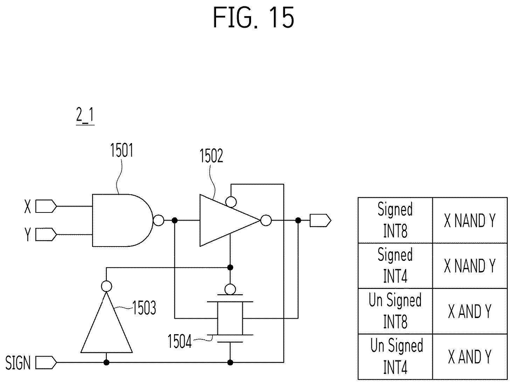

A fifth arithmetic unit 2_1 may output the results of a NAND operation by performing the NAND operation on input values that are input to the fifth arithmetic unit 2_1 after the start of a signed operation and may output the results of an AND operation by performing the AND operation on input values that are input to the fifth arithmetic unit 2_1 after the start of an unsigned operation. It may be seen that in the arithmetic matrix 820, arithmetic units for (0,7) to (2,7) and arithmetic units for (7,0) to (7,2) on the basis of a bit of the X input and a bit of the Y input are the fifth arithmetic units 2_1. The fifth arithmetic unit 2_1 for (2,7) may perform an arithmetic operation of XY27 in FIGS. 4 and 5 and an arithmetic operation of XY27' in FIGS. 6 and 7. FIG. 15 illustrates an embodiment of the fifth arithmetic unit 2_1. It may be seen that the fifth arithmetic unit 2_1 includes a NAND gate 1501, a tri-state inverter 1502, an inverter 1503, and a pass gate 1504. The fifth arithmetic unit 2_1 may output the results of a NAND operation by performing the NAND operation on input signals X and Y after the start of a signed operation in which the signal SIGN is 1 and may output the results of an AND operation by performing the AND operation on the input signals X and Y after the start of an unsigned operation in which the signal SIGN is 0.

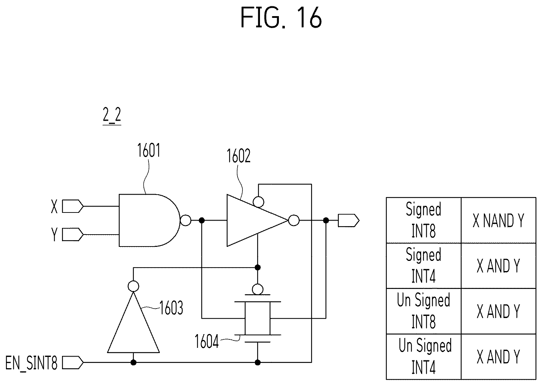

A sixth arithmetic unit 2_2 may output the results of a NAND operation by performing the NAND operation on input values that are input to the sixth arithmetic unit 2_2 after the start of a signed operation in the high-precision operation mode and may output the results of an AND operation by performing the AND operation on input values that are input to the sixth arithmetic unit 2_2 after the start of an unsigned operation in the high-precision operation mode. It may be seen that in the arithmetic matrix 820, an arithmetic unit for (7,3) and (3,7) on the basis of a bit of the X input and a bit of the Y input is the sixth arithmetic units 2_2. The sixth arithmetic unit 2_2 for (3,7) may perform an arithmetic operation of XY37 in FIGS. 4, 5, and 7 and an arithmetic operation of XY37' in FIG. 6. FIG. 16 illustrates an embodiment of the sixth arithmetic unit 2_2. It may be seen that the sixth arithmetic unit 2_2 includes a NAND gate 1601, a tri-state inverter 1602, an inverter 1603, and a pass gate 1604. The sixth arithmetic unit 2_2 may output the results of a NAND operation by performing the NAND operation on input signals X and Y that are input to the sixth arithmetic unit 2_2 after the start of a signed operation in the high-precision mode in which the signal EN_SINT8 is 1 and may output the results of an AND operation by performing the AND operation on the input signals X and Y that are input to the sixth arithmetic unit 2_2 after the start of an unsigned operation in the high-precision mode and the start of an unsigned operation in the low-precision mode in which the signal EN_SINT8 is 0.

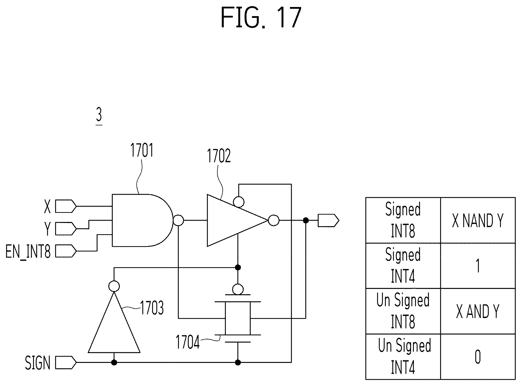

A seventh arithmetic unit 3 may output the results of a NAND operation by performing the NAND operation on input values that are input to the seventh arithmetic unit 3 after the start of a signed operation in the high-precision operation mode, output the results of an AND operation by performing the AND operation on input values that are input to the seventh arithmetic unit 3 after the start of an unsigned operation in the high-precision operation mode, output 1 after the start of a signed operation in the low-precision operation mode, and output 0 after the start of an unsigned operation in the low-precision operation mode. It may be seen that in the arithmetic matrix 820, arithmetic units for (4,7) to (6,7) and arithmetic units for (7,4) to (7,6) on the basis of a bit of the X input and a bit of the Y input are the seventh arithmetic units 3. The seventh arithmetic unit 3 for (4,7) may perform an arithmetic operation of XY47 in FIG. 4, a 0 output operation in FIG. 5, an arithmetic operation of XY47' in FIG. 6, and a 1 output operation in FIG. 7. FIG. 17 illustrates an embodiment of the seventh arithmetic unit 3. It may be seen that the seventh arithmetic unit 3 includes a NAND gate 1701, a tri-state inverter 1702, an inverter 1703, and a pass gate 1704. The seventh arithmetic unit 3 may output the results of a NAND operation by performing the NAND operation on input signals X and Y that are input to the seventh arithmetic unit 3 when the signal EN_INT8 is 1 and the signal SIGN is 1, output 1 when the signal EN_INT8 is 0 and the signal SIGN is 1, output the results of an AND operation by performing the AND operation on the input signals X and Y that are input to the seventh arithmetic unit 3 when the signal EN_INT8 is 1 and the signal SIGN is 0, and output 0 when the signal EN_INT8 is 0 and the signal SIGN is 0.

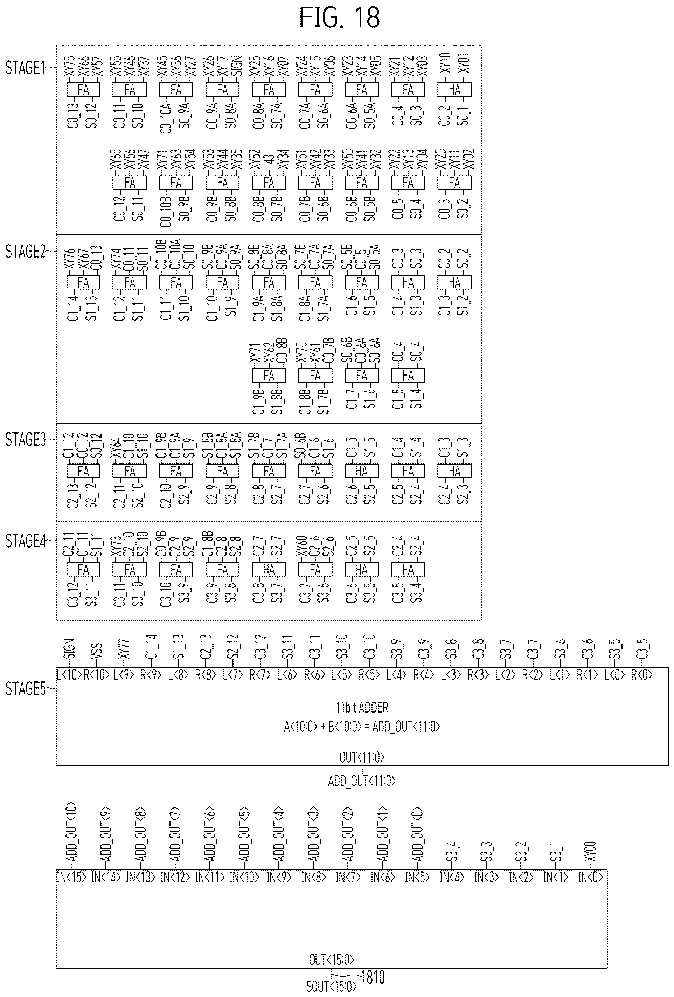

FIG. 18 is a construction diagram according to an embodiment of the adder array 830 illustrated in FIG. 8.

Referring to FIG. 18, the adder array 830 may include first to fifth stages STAGE1 to STAGE5 and a 16-bit latch 1810.

Each of the first to fourth stages STAGE1 to STAGE4 may include half adders HA and full adders FA. The first stage STAGE1 may add the operation results of the arithmetic matrix 820 by using the half adder HA and the full adder FA. The half adder HA and full adder FA of the second stage STAGE2 may add the operation results of the half adder HA and full adder FA of the first stage STAGE1. The half adder HA and full adder FA of the third stage STAGE3 may add the operation results of the second stage STAGE2. Likewise, the half adder HA and full adder FA of the fourth stage STAGE4 may add the operation results of the third stage STAGE3.

The fifth stage STAGE5 includes a 11-bit adder. The 11-bit adder may output a result ADD_OUT<11:0> by adding values that are input to terminals L<10:0> and values that are input to terminals R<11:0>.

The 16-bit latch 1810 may store bits that are input to input terminals IN<15:0>, and may output the stored bits as a result value SOUT<15:0>. As described above, in the high-precision operation mode, the result value SOUT<15:0> corresponds to S<15:0> in FIGS. 4 and 6. Furthermore, in the low-precision operation mode, the result value SOUT<15:4> corresponds to S<11:0> in FIGS. 5 and 7. Furthermore, after the start of a signed operation, the most significant bit SOUT<15> of the result value may indicate a sign.

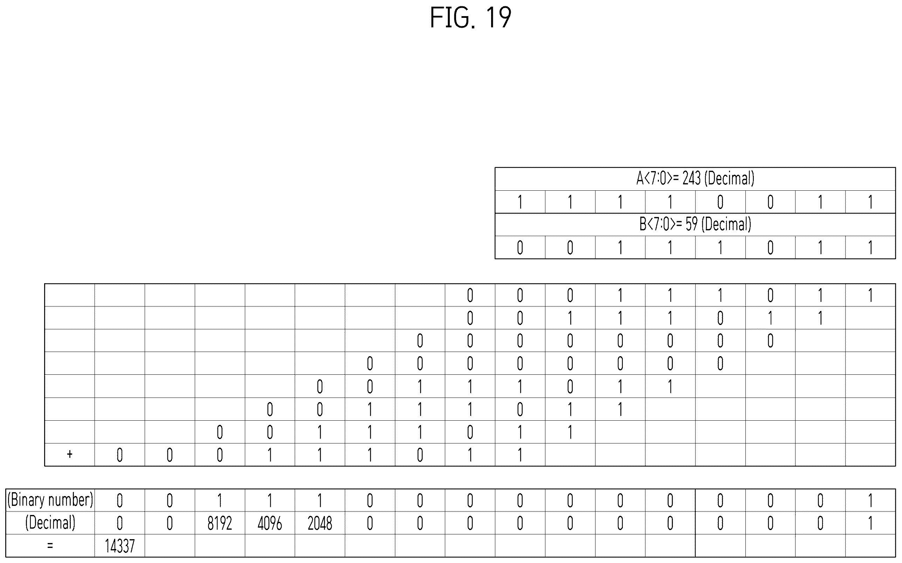

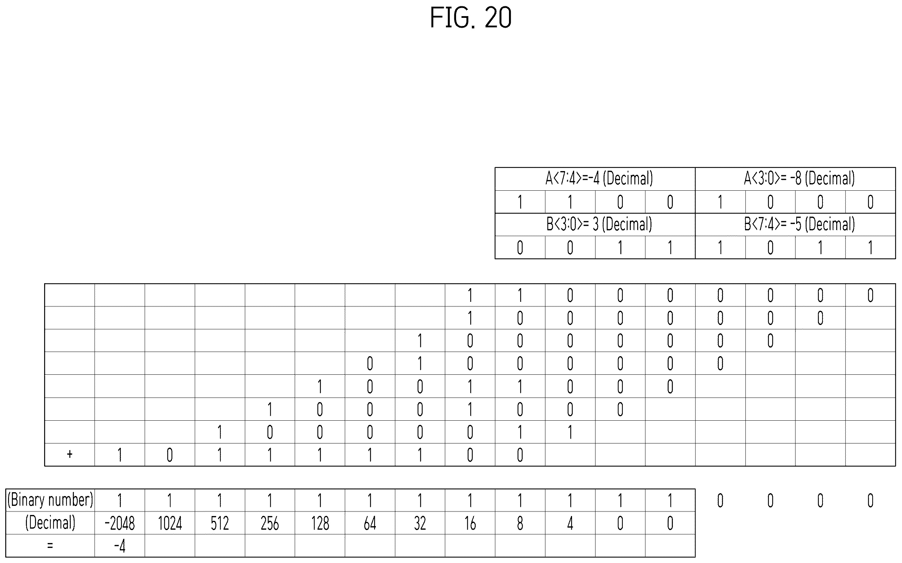

FIGS. 19 and 20 are diagrams illustrating an example of an arithmetic operation of the arithmetic circuit 210_0.

FIG. 19 illustrates an example of an unsigned INT8 arithmetic operation that is performed by the arithmetic circuit 210_0. An arithmetic operation of A*B=245*59=14337 is performed. 245 of A corresponds to 11110011 in binary numbers. 59 of B corresponds to 00111011 in binary numbers. 0011100000000001, that is, binary numbers, are obtained as the results of a multiplication operation of 11110011 and 00111011, which correspond to 14337 in decimal numbers.

FIG. 20 illustrates an example of a signed INT4 arithmetic operation that is performed by the arithmetic circuit 210_0. An arithmetic operation of (-8)*3 + (-4)* (-5) = -24+20 = -4 is performed. -8 corresponds to 1000 in binary numbers, and 3 corresponds to 0011 in binary numbers. Furthermore, -4 corresponds to 1100 in binary numbers, and -5 corresponds to 1011 in binary numbers. 111111111100, that is, binary numbers, are obtained by adding two multiplication operations and the results of the multiplication operations, which correspond to -4 in a decimal number.

Although embodiments according to the technical spirit of the present disclosure have been described above with reference to the accompanying drawings, the embodiments have been provided to merely describe embodiments according to the concept of the present disclosure, and the present disclosure is not limited to the embodiments. A person having ordinary knowledge in the art to which the present disclosure pertains may substitute, modify, and change the embodiments in various ways without departing from the technical spirit of the present disclosure written in the claims. Such substitutions, modifications, and changes may be said to belong to the scope of the present disclosure.

## Claims

1. An arithmetic circuit comprising:
an arithmetic matrix comprising a plurality of arithmetic units each configured to receive one of a plurality of bits of an X input and one of a plurality of bits of a Y input and configured to perform an arithmetic operation on the received bits; and
an adder array configured to generate a result value by adding operation results of the arithmetic matrix,
wherein a first group, among the plurality of arithmetic units, outputs results of an AND operation by performing the AND operation on values that are input to respective arithmetic units, and
wherein a second group, among the plurality of arithmetic units, outputs results of different arithmetic operations by performing the different arithmetic operations in a high-precision operation mode and a low-precision operation mode.

2. The arithmetic circuit of claim 1, wherein the plurality of arithmetic units of the arithmetic matrix comprises:
first arithmetic units each configured to output results of an AND operation by performing the AND operation on values that are input to respective first arithmetic units;
second arithmetic units each configured to output results of an AND operation by performing the AND operation on values that are input to respective second arithmetic units in the high-precision operation mode and configured to output 0 in the low-precision operation mode;
third arithmetic units each configured to output results of an AND operation by performing the AND operation on values that are input to respective third arithmetic units in the high-precision operation mode, configured to output 1 after a start of a signed operation in the low-precision operation mode, and configured to output 0 after a start of an unsigned operation in the low-precision operation mode;
fourth arithmetic units each configured to output results of an AND operation by performing the AND operation on values that are input to respective fourth arithmetic units after a start of a signed operation in the high-precision operation mode, configured to output results of a NAND operation by performing the NAND operation on values that are input to respective fourth arithmetic units after a start of a signed operation in the low-precision operation mode, and configured to output results of an AND operation by performing the AND operation on values that are input to respective fourth arithmetic units after a start of an unsigned operation in the high-precision operation mode and the low-precision operation mode;
fifth arithmetic units each configured to output results of a NAND operation by performing the NAND operation on values that are input to respective fifth arithmetic units after a start of a signed operation and configured to output results of an AND operation by performing the AND operation on values that are input to respective fifth arithmetic units after a start of an unsigned operation;
sixth arithmetic units each configured to output results of a NAND operation by performing the NAND operation on values that are input to respective sixth arithmetic units after a start of a signed operation in the high-precision operation mode and configured to output results of an AND operation by performing the AND operation on values that are input to respective sixth arithmetic units after a start of an unsigned operation in the high-precision operation mode and in the low-precision operation mode; and
seventh arithmetic units each configured to output results of a NAND operation by performing the NAND operation on values that are input to respective seventh arithmetic units after a start of a signed operation in the high-precision operation mode, configured to output results of an AND operation by performing the AND operation on values that are input to respective seventh arithmetic units after a start of an unsigned operation in the high-precision operation mode, configured to output 1 after a start of a signed operation in the low-precision operation mode, and configured to output 0 after a start of an unsigned operation in the low-precision operation mode.

3. The arithmetic circuit of claim 2, wherein a number of the plurality of arithmetic units included in the arithmetic matrix is (a number of the bits of the X input) * (a number of the bits of the Y input).

4. The arithmetic circuit of claim 2, further comprising an input register configured to transmit bits of a first input as the bits of the X input, configured to transmit bits of a second input as the bits of the Y input, and configured to make different corresponding relations between the bits of the second input and the bits of the Y input in the high-precision operation mode compared to that of the low-precision operation mode.

5. The arithmetic circuit of claim 2,
wherein the adder array comprises N stages, N being an integer equal to or greater than 2,
wherein each of the first to (N-1)-th stages comprises at least one half adder and multiple full adders, and
wherein the N-th stage comprises a multi-bit adder.

6. The arithmetic circuit of claim 2,
wherein the high-precision operation mode is an INT8 mode, and
wherein the low-precision operation mode is an INT4 mode.

7. An arithmetic circuit comprising:
an arithmetic matrix comprising sixty-four arithmetic units arranged 8×8 and each configured to receive one of 8 bits of an X input and one of 8 bits of a Y input and configured to perform an arithmetic operation on the received bits; and
an adder array configured to generate a result value by adding operation results of the arithmetic matrix,
wherein a first group, among the sixty-four arithmetic units, outputs results of an AND operation by performing the AND operation on values that are input to respective arithmetic units, and
wherein a second group, among the sixty-four arithmetic units, outputs results of different arithmetic operations by performing the different arithmetic operations in a high-precision operation mode and a low-precision operation mode.

8. The arithmetic circuit of claim 7, wherein the sixty-four arithmetic units of the arithmetic matrix comprise:
first arithmetic units each configured to output results of an AND operation by performing the AND operation on values that are input to respective first arithmetic units;
second arithmetic units each configured to output results of an AND operation by performing the AND operation on values that are input to respective second arithmetic units in the high-precision operation mode and configured to output 0 in the low-precision operation mode;
third arithmetic units each configured to output results of an AND operation by performing the AND operation on values that are input to respective third arithmetic units in the high-precision operation mode, configured to output 1 after a start of a signed operation in the low-precision operation mode, and configured to output 0 after a start of an unsigned operation in the low-precision operation mode;
fourth arithmetic units each configured to output results of an AND operation by performing the AND operation on values that are input to respective fourth arithmetic units after a start of a signed operation in the high-precision operation mode, configured to output results of a NAND operation by performing the NAND operation on values that are input to respective fourth arithmetic units after a start of a signed operation in the low-precision operation mode, and configured to output results of an AND operation by performing the AND operation on values that are input to respective fourth arithmetic units after a start of an unsigned operation in the high-precision operation mode and the low-precision operation mode;
fifth arithmetic units each configured to output results of a NAND operation by performing the NAND operation on values that are input to respective fifth arithmetic units after a start of a signed operation and configured to output results of an AND operation by performing the AND operation on values that are input to respective fifth arithmetic units after a start of an unsigned operation;
sixth arithmetic units each configured to output results of a NAND operation by performing the NAND operation on values that are input to respective sixth arithmetic units after a start of a signed operation in the high-precision operation mode and configured to output results of an AND operation by performing the AND operation on values that are input to respective sixth arithmetic units after a start of an unsigned operation in the high-precision operation mode and in the low-precision operation mode; and
seventh arithmetic units each configured to output results of a NAND operation by performing the NAND operation on values that are input to respective seventh arithmetic units after a start of a signed operation in the high-precision operation mode, configured to output results of an AND operation by performing the AND operation on values that are input to respective seventh arithmetic units after a start of an unsigned operation in the high-precision operation mode, configured to output 1 after a start of a signed operation in the low-precision operation mode, and configured to output 0 after a start of an unsigned operation in the low-precision operation mode.

9. The arithmetic circuit of claim 8,
wherein, in relation to a bit of the X input and a bit of the Y input in the arithmetic matrix:
arithmetic units for (0,4) to (2,6) and arithmetic units for (4,0) to (6,2) are the first arithmetic units,
arithmetic units for (0,0) to (3,3), arithmetic units for (4,5) to (6,6), an arithmetic unit for (5,4), and an arithmetic unit for (6,4) are the second arithmetic units,
an arithmetic unit for (4,4) is the third arithmetic unit,
arithmetic units for (3,4) to (3,6) and arithmetic units for (4,3) to (6,3) are the fourth arithmetic units,
arithmetic units for (0,7) to (2,7) and arithmetic units for (7,0) to (7,2) are the fifth arithmetic units,
an arithmetic unit for (3,7) and an arithmetic unit for (7,3) are the sixth arithmetic units, and
arithmetic units for (4,7) to (6,7) and arithmetic units for (7,4) to (7,6) are the seventh arithmetic units.

10. The arithmetic circuit of claim 9, further comprising an input register configured to transmit 8 bits of a first input as the 8 bits of the X input and configured to transmit 8 bits of a second input as the 8 bits of the Y input,
wherein the input register:
transmits a 0-th bit to seventh bit of the first input as a 0-th bit to seventh bit of the X input and transmits a 0-th bit to seventh bit of the second input as a 0-th bit to seventh bit of the Y input in the high-precision operation mode, and
transmits the 0-th bit to seventh bit of the first input as the 0-th bit to seventh bit of the X input, transmits 0-th bit to third bit of the second input as fourth bit to seven bit of the Y input, and transmit fourth bit to seventh bit of the second input as 0-th bit to third bit of the Y input in the low-precision operation mode.

11. The arithmetic circuit of claim 10,
wherein the high-precision operation mode is an INT8 mode, and
wherein the low-precision operation mode is an INT4 mode.

12. The arithmetic circuit of claim 11, wherein, in the high-precision operation mode, the result value is a multiplication value of the 8 bits of the first input and the 8 bits of the second input.

13. The arithmetic circuit of claim 11,
wherein, in the low-precision operation mode, the result value is an addition value of a first multiplication value and a second multiplication value,
wherein the first multiplication value is a multiplication value of 4 bits from the 0-th bit to third bit of the first input and 4 bits from the 0-th bit to third bit of the second input, and
wherein the second multiplication value is a multiplication value of 4 bits from the 0-th bit to third bit of the first input and 4 bits from the 0-th bit to third bit of the second input.

14. The arithmetic circuit of claim 9,
wherein the adder array comprises N stages, N being an integer equal to or greater than 2,
wherein each of the first to (N-1)-th stages comprises at least one half adder and multiple full adders, and
wherein the N-th stage comprises a multi-bit adder.

15. Memory comprising:
a cell array;
an input register configured to transmit 8 bits of a first input that is read from the cell array as 8 bits of an X input and configured to transmit 8 bits of a second input that is received from an outside of the memory as 8 bits of a Y input;
an arithmetic matrix comprising sixty-four arithmetic units arranged 8×8 and each configured to receive one of the 8 bits of the X input and one of the 8 bits of the Y input and configured to perform an arithmetic operation on the received bits; and
an adder array configured to generate a result value by adding operation results of the arithmetic matrix,
wherein a first group, among the sixty-four arithmetic units, outputs results of an AND operation by performing the AND operation on values that are input to respective arithmetic units, and
wherein a second group, among the sixty-four arithmetic units, outputs results of different arithmetic operations by performing the different arithmetic operations in a high-precision operation mode and a low-precision operation mode.
